# EUROPEAN PATENT SPECIFICATION

(11) **EP 3 933 911 B1**
(45) Date of publication and mention of the grant of the patent: **13.12.2023**
(21) Application number: 20917272.5
(22) Date of filing: 28.12.2020
(51) Int. Cl.: H01L 23/34, H01L 23/367, H01L 23/473, H01L 25/065, H05K 7/20

(54) **LIQUID COOLING HEAT RADIATOR AND COMMUNICATION DEVICE**
FLÜSSIGKEITSKÜHLENDER WÄRMESTRAHLER UND KOMMUNIKATIONSVORRICHTUNG
ÉLÉMENT RAYONNANT DE CHALEUR À REFROIDISSEMENT LIQUIDE ET DISPOSITIF DE COMMUNICATION

(30) Priority: 30.04.2020 CN 202010360883
(43) Date of publication of application: 05.01.2022
(73) Proprietor: Huawei Digital Power Technologies Co., Ltd., Shenzhen, 518043 (CN)
(72) Inventor: YE, Wen, Shenzhen Guangdong 518129 (CN); CHEN, Jun, Shenzhen Guangdong 518129 (CN); LI, Quanming, Shenzhen Guangdong 518129 (CN)
(74) Representative: Pfenning, Meinig & Partner mbB
(86) International application number: PCT/CN2020/140150
(87) International publication number: WO 2021/218213

(56) References cited:
- EP-A1- 3 531 234
- EP-A2- 2 194 440
- CN-A- 107 068 636
- CN-A- 109 920 768
- CN-A- 110 993 576
- CN-A- 111 653 529
- CN-U- 209 461 449
- JP-A- 2003 046 279
- JP-A- 2016 062 919

## Description

### TECHNICAL FIELD

This application relates to the field of heat dissipation technologies, and in particular, to a liquid cooling cold plate and a communications device.

### BACKGROUND

Currently, a semiconductor component has an increasingly large power density, and there are many heat generating wafers that are concentrated in a neighboring region. Therefore, a liquid cooling cold plate is required to have high heat dissipation efficiency, and can dissipate heat for heat sources that are at different locations and that generate heat differently. A temperature difference between the heat sources also needs to be maintained within a proper range.

When an existing liquid cooling cold plate dissipates heat for a high-power semiconductor component, a fluid channel is not optimized due to a difference between distribution locations and heat losses of wafers. Consequently, there is a large temperature difference between a wafer with a high heat flux density and a wafer with a low heat flux density inside the component, and the wafer with the high heat flux density inside the component may have excessively high temperature, causing an overtemperature risk of the component.

Currently, there are the following two main types of liquid cooling cold plates for a semiconductor: One is a liquid cooling cold plate with sparse and dense fins. For different heat sources generating heat differently, fins with different densities are disposed in corresponding fluid channels corresponding to the heat sources to balance heat dissipation. The other is an independent fluid channel design. Fluid channels under different heat sources are independently designed to dissipate heat in different regions. However, the liquid cooling cold plate designed in the two design manners has a complex fluid channel design manner when there are a plurality of heat sources.
CN 110 993 576 A discloses a heat dissipation device and communication equipment. The heat dissipation device comprises a heat dissipation shell and a heat dissipation channel arranged in the heat dissipation shell. The heat dissipation shell is provided with at least two heat dissipation areas used for being connected with a component in a heat conduction mode, and fluid in the heat dissipation channel flows through the heat dissipation areas. A splitter plate is arranged in the heat dissipation shell in the flowing direction of fluid and divides the heat dissipation channel into a main flow channel and a branch flow channel. And the splitter plate is provided with a through hole for converging into the main runner. According to the technical scheme, heat dissipation is conducted on the heat dissipation area through fluid in the main flow channel. And the low-temperature fluid in the sub-runners is converged into the main runner to reduce the heat of the fluid in the main runner part corresponding to the downstream heat dissipation region.
JP 2016 062919 A discloses an electronic component mounting member, comprising: a flexible substrate, having flexibility, for connecting with another member, comprising: a main unit portion on which electronic components are mounted, and an extending portion, formed extending from the main unit portion, and having a terminal for connecting to another member; and a bending suppressing member disposed in the vicinity of a boundary line between the main unit portion and the extending portion, wherein: the flexible substrate has a cutout formed in the vicinity of the boundary line, and is connected to the other member in a state wherein the boundary line is bent.

### SUMMARY

This application provides a liquid cooling cold plate and a communications device, to simplify a fluid channel design and improve a heat dissipation effect on an electronic component.

According to a first aspect, a liquid cooling cold plate is provided, where the liquid cooling cold plate is applied to a communications device, and is configured to dissipate heat for an electronic component in the communications device. The liquid cooling cold plate includes a housing and at least two heat dissipation regions arranged on the housing in a flow direction of fluid, direction a. Heat sources disposed in the heat dissipation regions have different heat dissipation requirements, so that different requirements are imposed on a flow rate of fluid in a fluid channel. Therefore, a fluid channel corresponding to each heat dissipation region is disposed in the housing, and each fluid channel is disposed to correspond to a heat dissipation requirement of a heat source in the heat dissipation region. To facilitate fluid flow and meet different flow rate requirements of different heat dissipation regions, according to the liquid cooling cold plate provided in this application, a re-allocation module is disposed between at least two adjacent fluid channels. Fluid in a fluid channel located upstream of the re-allocation module is converged by using the re-allocation module, and the converged fluid is distributed to a downstream fluid channel by using the re-allocation module. It can be learned from the foregoing description that, the fluid in the upstream fluid channel is converged by using the re-allocation module, and the entire converged fluid is re-allocated to a downstream heat dissipation region, so that corresponding flow rates can be provided to regions with different heat dissipation requirements in the downstream heat dissipation region.

The re-allocation module has regions with different fluid resistance, and allocates the converged fluid to different regions in the downstream fluid channel based on a specified flow rate by using the regions with different fluid resistance. Different fluid resistance is set by using the re-allocation module, to achieve a re-allocation effect for the fluid. Each heat dissipation region includes at least two heat dissipation sub-regions arranged in a direction b, which is perpendicular to the flow direction. Powers of components in the heat dissipation sub-regions are different.

The re-allocation module includes a convergence cavity and a distribution module, where the convergence cavity is connected to the upstream fluid channel, and is configured to converge the fluid in the upstream fluid channel; and distribution channels are disposed on the distribution module, and the distribution channels are separately connected to the convergence cavity and the downstream fluid channel. The fluid in the upstream fluid channel is converged by using the convergence cavity, and the converged fluid is distributed again by using the distribution module. Fluid in the upstream fluid channel is converged by using the convergence cavity, and the converged fluid is distributed again by using the distribution module.

In a specific implementable solution, the distribution module includes a plurality of distribution plates, the convergence cavity is surrounded by the distribution plates, the plurality of distribution plates are spaced from each other by gaps, and the gaps are the distribution channels. Different fluid resistance is implemented by using the distribution plates, and the gaps disposed between the distribution plates form the distribution channels to control flow rates of fluid allocated to different downstream regions.

In a specific implementable solution, the distribution plates are arc-shaped distribution plates, and a semi-cylindrical convergence cavity is surrounded by the distribution plates, and an opening direction of the convergence cavity faces the upstream fluid channel, to facilitate convergence.

In a specific implementable solution, the distribution module includes a stopper 125, a plurality of through holes are disposed on the stopper 125, and the plurality of through holes are the distribution channels. Different fluid resistance is implemented by using the stopper, and distribution is performed by using the through holes.

In a specific implementable solution, pore sizes of through holes in different flow blocking regions are different. Therefore, different regions can correspond to different fluid resistance.

In a specific implementable solution, the through holes may be circular holes or rectangular holes.

In a specific implementable solution, the stopper is a rectangular stopper, and a length direction of the stopper is perpendicular to the flow direction of the fluid.

In a specific implementable solution, different shapes may be alternatively selected for the stopper, such as a V shape or an arc-shaped shape. However, regardless of which shape is selected, a concave direction of the stopper faces the upstream fluid channel.

In a specific implementable solution, at least two heat dissipation sub-regions that have different heat dissipation requirements are disposed in the downstream heat dissipation region; and the distribution module further includes a baffle plate, and the baffle plate extends in the flow direction of the fluid and is configured to space any two adjacent heat dissipation sub-regions. The downstream heat dissipation region is divided again by using the baffle plate, and flow rates of fluid is separated by using the baffle plate.

In a specific implementable solution, when the distribution module includes the stopper, the stopper and the baffle plate have an integral structure, to facilitate production.

In a specific implementable solution, a plurality of heat dissipation fins are disposed in each fluid channel, to improve a heat dissipation effect.

In a specific implementable solution, the housing includes a base plate and an upper cover covering the base plate, and the re-allocation module and the fluid channel in each heat dissipation region are located in a cavity surrounded by the upper cover and the base plate.

In a specific implementable solution, the re-allocation module is disposed on the base plate.

According to a second aspect, a communications device is provided, where the communications device includes the liquid cooling cold plate in any one of the foregoing implementations and an electronic component disposed in each heat dissipation region. It can be learned from the foregoing description that, the fluid in the upstream fluid channel is converged by using the re-allocation module, and the entire converged fluid is re-allocated to a downstream heat dissipation region, so that corresponding flow rates can be provided to regions with different heat dissipation requirements in the downstream heat dissipation region.

### BRIEF DESCRIPTION OF DRAWINGS

FIG. 1 is a schematic diagram of an application scenario of a liquid cooling cold plate according to an embodiment of this application;
FIG. 2 is a schematic diagram of heat dissipation regions corresponding to a liquid cooling cold plate according to an embodiment of this application;
FIG. 3 is a schematic exploded diagram of a liquid cooling cold plate according to an embodiment of this application;
FIG. 4 is a schematic diagram of fluid channels of a liquid cooling cold plate according to an embodiment of this application;
FIG. 5 is a schematic structural diagram of a distribution module of a liquid cooling cold plate according to an example helpful to understand this application;
FIG. 6 is another schematic structural diagram of a distribution module of a liquid cooling cold plate according to an example helpful to understand this application;
FIG. 7 is a schematic diagram when a liquid cooling cold plate corresponds to a plurality of heat dissipation regions according to an embodiment of this application; and
FIG. 8 is a schematic diagram of a baffle plate when a liquid cooling cold plate corresponds to a plurality of heat dissipation regions according to an embodiment of this application.

### DESCRIPTION OF EMBODIMENTS

To make the objectives, technical solutions, and advantages of this application clearer, the following further describes this application in detail with reference to the accompanying drawings.

First, an application scenario of a heat dissipation apparatus is described. The heat dissipation apparatus provided in the embodiments of this application is configured to dissipate heat for a high-power semiconductor component. With development of a current electronic device, the electronic device includes increasingly more high-power components, and has a higher requirement on the heat dissipation apparatus. In addition, because smaller space is left for a heat dissipation component as the current electronic device develops towards miniaturization and integration, a heat dissipation capability of the high-power semiconductor component in case of a high power density needs to be urgently improved. Therefore, the embodiments of this application provide a heat dissipation apparatus, configured to improve a heat dissipation effect on the high-power component in the electronic device.

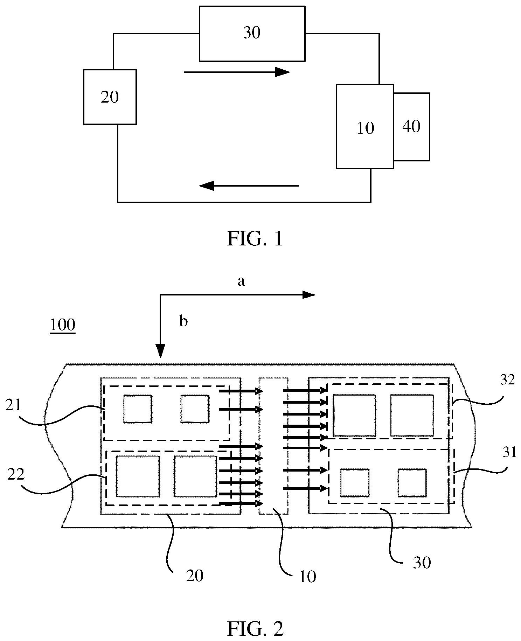

FIG. 1 illustrates an application scenario of a liquid cooling cold plate according to an embodiment of this application. A liquid cooling cold plate 100 provided in this embodiment of this application is configured to dissipate heat for a high-power semiconductor component 400. As shown in FIG. 1, the liquid cooling cold plate 100 is connected to an external heat dissipation system to form a heat dissipation loop. For example, the external heat dissipation system in FIG. 1 includes a pump 300 and a condenser 200. The pump 300 and the condenser 200 are connected to the liquid cooling cold plate 100 by using a pipeline, to form the heat dissipation loop. The heat dissipation loop is filled with fluid. Under an action of the pump 300, the fluid may flow in the heat dissipation loop. A direction shown by an arrow shown in FIG. 1 is a flow direction of the fluid. For ease of description, the flow direction of the fluid is defined as a first direction. The liquid cooling cold plate 100 is thermally conductively connected to the high-power semiconductor component 400. During heat dissipation, heat generated by the high-power semiconductor component 400 is transferred to the liquid cooling cold plate 100, and is transferred to fluid in the liquid cooling cold plate 100 by using the liquid cooling cold plate 100. Temperature of the fluid increases. The high-temperature fluid enters the condenser 200 under the action of the pump 300 to condense and cool down to form low-temperature fluid. The low-temperature fluid flows into the liquid cooling cold plate 100 again, so that the heat generated by the high-power semiconductor component 400 can be continuously removed.

The foregoing fluid may be kerosene, water, or another common fluid medium.

The foregoing high-power semiconductor component 400 may be different components such as a chip, an IGBT, or another common high-power semiconductor component. For ease of description, the high-power semiconductor component is briefly referred to as a component.

FIG. 2 is a schematic diagram of heat dissipation regions corresponding to a liquid cooling cold plate. For ease of description, a direction a is introduced, and the direction a is a flow direction of fluid in a liquid cooling cold plate 100. At least two heat dissipation regions are disposed on the liquid cooling cold plate 100, and the at least two heat dissipation regions are arranged in the flow direction of the fluid in the liquid cooling cold plate 100. FIG. 2 illustrates only two heat dissipation regions: a first heat dissipation region 20 and a second heat dissipation region 30. The first heat dissipation region 20 and the second heat dissipation region 30 are arranged in the direction a.

Each heat dissipation region of the first heat dissipation region 20 and the second heat dissipation region 30 includes at least two heat dissipation sub-regions arranged in a direction b. Powers of components in the heat dissipation sub-regions are different, that is, the components in the heat dissipation sub-regions generate heat differently, and therefore have different corresponding heat dissipation requirements. The first heat dissipation region 20 and the second heat dissipation region 30 are used as an example. The first heat dissipation region 20 includes a first heat dissipation sub-region 21 and a second heat dissipation sub-region 22 that are arranged in the direction b. Heat dissipation requirements of components in the first heat dissipation sub-region 21 and the second heat dissipation sub-region 22 are different. The component in the first heat dissipation sub-region 21 has a lower power, and has a lower heat dissipation requirement. The component in the second heat dissipation sub-region 22 has a higher power, and has a higher heat dissipation requirement. Therefore, a flow rate of fluid corresponding to the first heat dissipation sub-region 21 is less than a flow rate of fluid corresponding to the second heat dissipation sub-region 22. The second heat dissipation region 30 includes a third heat dissipation sub-region 31 and a fourth heat dissipation sub-region 32 that are arranged in the direction b. Heat dissipation requirements of components in the third heat dissipation sub-region 31 and the fourth heat dissipation sub-region 32 are different. The component in the third heat dissipation sub-region 31 has a lower power, and has a lower heat dissipation requirement. The component in the fourth heat dissipation sub-region 32 has a higher power, and has a higher heat dissipation requirement. Therefore, a flow rate of fluid corresponding to the third heat dissipation sub-region 31 is less than a flow rate of fluid corresponding to the fourth heat dissipation sub-region 32.

In an optional implementation solution, the heat dissipation region provided in this embodiment of this application may alternatively include different quantities of heat dissipation sub-regions, for example, three or four. For example, in the structure shown in FIG. 2, two adjacent heat dissipation regions may include a same quantity of heat dissipation sub-regions. Alternatively, two adjacent heat dissipation regions include different quantities of heat dissipation sub-regions, for example, one heat dissipation region includes three heat dissipation sub-regions, and the other heat dissipation region includes four heat dissipation sub-regions or two heat dissipation sub-regions.

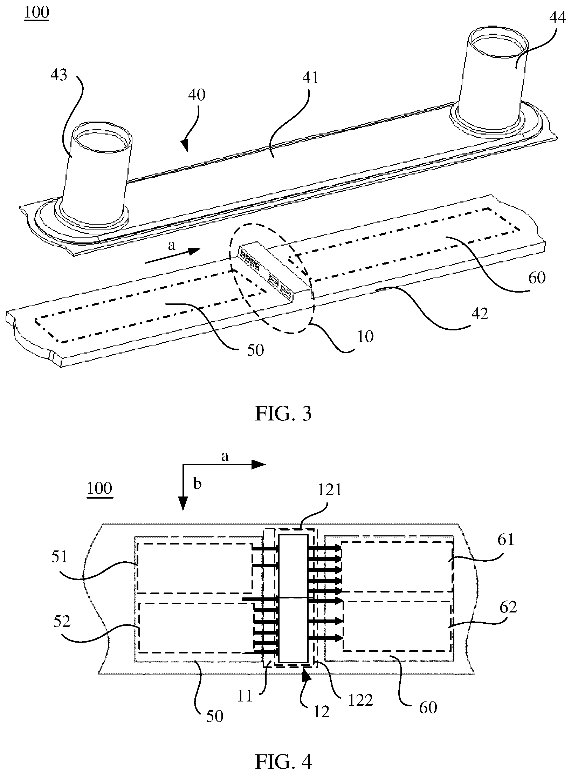

The two heat dissipation regions shown in FIG. 2 are used as an example to describe fluid flow of the liquid cooling cold plate 100 in this embodiment of this application. For ease of description, the fluid corresponding to the first heat dissipation sub-region 21 is first fluid, the fluid corresponding to the second heat dissipation sub-region 22 is second fluid, the fluid corresponding to the third heat dissipation sub-region 31 is third fluid, and the fluid corresponding to the fourth heat dissipation sub-region 32 is fourth fluid. As shown in FIG. 2, the first fluid and the third fluid are arranged in the direction a, and the second fluid and the fourth fluid are arranged in the direction a. To ensure that heat of the components in the first heat dissipation sub-region 21, the second heat dissipation sub-region 22, the third heat dissipation sub-region 31, and the fourth heat dissipation sub-region 32 can be well dissipated, a flow rate needs to be increased when the first fluid flows to the third fluid, and a flow rate needs to be decreased when the second fluid flows to the fourth fluid, to ensure heat dissipation effects on the components in the third heat dissipation sub-region 31 and the fourth heat dissipation sub-region 32. Because a total amount of fluid flowing through the first heat dissipation region 20 and the second heat dissipation region 30 does not change, the fluid needs to be re-allocated when flowing from the first heat dissipation region 20 to the second heat dissipation region 30. In this application, the fluid is re-allocated by using a re-allocation module 10 located between the first heat dissipation region 20 and the second heat dissipation region 30. A quantity of arrows shown in FIG. 2 represents a value of a flow rate, and the re-allocation module 10 is disposed between the first heat dissipation region 20 and the second heat dissipation region 30. After flowing through the first heat dissipation region 20, the fluid is re-allocated by using the re-allocation module 10, so that the fluid can meet a flow rate requirement of each heat dissipation sub-region in the second heat dissipation region 30 on the fluid. With reference to FIG. 3, the following describes in detail a structure and working of the re-allocation module 10 provided in this embodiment of this application.

FIG. 3 is a schematic exploded diagram of a liquid cooling cold plate according to an embodiment of this application. The liquid cooling cold plate 100 provided in this embodiment of this application includes a housing 40, and the housing 40 is configured to bear a component. The foregoing heat dissipation regions are all disposed on a surface of the housing 40, and a channel used for fluid flow is disposed in the housing 40. In addition, a liquid inlet 43 and a liquid outlet 44 that are connected to the fluid channel are disposed on the housing 40, and the liquid inlet 43 and the liquid outlet 44 may be connected to an external heat dissipation system by using a pipeline, to form a heat dissipation loop.

Referring to the direction a, the direction a points from the liquid inlet 43 to the liquid outlet 44, and fluid flows in the channel in the direction a from the liquid inlet 43 to the liquid outlet 44. The channel may be divided into a plurality of fluid channels in the direction a, and the plurality of fluid channels are in a one-to-one correspondence with the heat dissipation regions. When the fluid flows through each fluid channel, heat dissipation may be performed on a component disposed in a heat dissipation region corresponding to the fluid channel. When there are two heat dissipation regions, there are also two fluid channels. A fluid channel shown in FIG. 3 is used as an example. The fluid channel is divided into a first fluid channel 50 and a second fluid channel 60 in the direction a, and the re-allocation module 10 is disposed between the first fluid channel 50 and the second fluid channel 60. A length direction of the re-allocation module 10 is disposed in the direction b to separate the first fluid channel 50 and the second fluid channel 60. The first fluid channel 50 is a fluid channel located upstream of the re-allocation module 10, and corresponds to the first heat dissipation region. The second fluid channel 60 is a fluid channel located downstream of the re-allocation module 10, and corresponds to the second heat dissipation region.

In an optional solution, a detachable structure may be used for the housing 40. As shown in FIG. 3, the housing 40 includes a base plate 42 and an upper cover 41 covering the base plate 42. The upper cover 41 and the base plate 42 may be fixedly connected to each other through bonding or welding or by using a threaded connecting piece (a bolt or a screw). When the upper cover 41 and the base plate 42 are connected, the upper cover 41 and the base plate 42 are sealed, for example, sealed by using sealing glue. The liquid inlet 43 and the liquid outlet 44 are disposed on the upper cover 41, and the heat dissipation region is disposed on a surface that is of the base plate 42 and that is away from the upper cover 41. The re-allocation module 10 and the fluid channel in each heat dissipation region are located in a cavity surrounded by the upper cover 41 and the base plate 42. For example, the re-allocation module 10 is disposed on the base plate 42. When the upper cover 41 covers the base plate 42, the re-allocation module 10 may separate the first fluid channel 50 and the second fluid channel 60.

In an optional solution, the housing 40 may be integrally formed. The upper cover 41, the base plate 42, and the re-allocation module 10 shown in FIG. 3 may be integrally produced and formed in a manner such as injection molding or 3D printing.

During application, fluid in the upstream fluid channel (the first fluid channel 50) is converged by using the re-allocation module 10, and the converged fluid is distributed to the downstream fluid channel (the second fluid channel 60) by using the re-allocation module 10. As shown in FIG. 3, the fluid in the first fluid channel 50 may be converged by using the re-allocation module 10, and the converged fluid may be allocated by the re-allocation module 10 based on requirements of different regions in the second fluid channel 60.

During specific implementation, the re-allocation module has regions with different fluid resistance, and allocates the converged fluid to different regions in the downstream fluid channel based on a specified flow rate by using the regions with different fluid resistance. As shown in FIG. 4, the first fluid channel 50 and the second fluid channel 60 are used as an example for description. For an arrangement manner of the first heat dissipation region and the second heat dissipation region that correspond to the first fluid channel 50 and the second fluid channel 60 in FIG. 4 and a manner of included heat dissipation sub-regions, refer to related descriptions in FIG. 2. The first fluid channel 50 includes a first subchannel 51 and a second subchannel 52 that are arranged in the direction b, the first subchannel 51 corresponds to the first heat dissipation sub-region, and the second subchannel 52 corresponds to the second heat dissipation sub-region. The second fluid channel 60 includes a third subchannel 61 and a fourth subchannel 62 that are arranged in the direction b, the third subchannel 61 corresponds to the third heat dissipation sub-region, and the fourth subchannel 62 corresponds to the fourth heat dissipation sub-region. The first fluid corresponding to the first heat dissipation sub-region flows in the first subchannel 51, the second fluid corresponding to the second heat dissipation sub-region flows in the second subchannel 52, the third fluid corresponding to the third heat dissipation sub-region flows in the third subchannel 61, and the fourth fluid corresponding to the fourth heat dissipation sub-region flows in the fourth subchannel 62. The re-allocation module includes a first flow blocking region 121 and a second flow blocking region 122. The first flow blocking region 121 is located between the first subchannel 51 and the third subchannel 61, and the second flow blocking region 122 is located between the second subchannel 52 and the fourth subchannel 62. The first flow blocking region 121 and the second flow blocking region 122 have different fluid resistance. The foregoing fluid resistance is fluid resistance applied to fluid by the first flow blocking region 121 and the second flow blocking region 122. Larger fluid resistance indicates a smaller flow rate of the fluid.

Referring to the arrangement manner of the components in the heat dissipation sub-region in FIG. 2, to ensure that the fluid can dissipate heat for the components in the second heat dissipation region well, fluid resistance of the first flow blocking region 121 is less than fluid resistance of the second flow blocking region 122. An example in which a total flow rate of fluid is Q1 is used. A flow rate of the first fluid in the first subchannel 51 is Q2, and a flow rate of the second fluid in the second subchannel 52 is Q3. A total flow rate of fluid in the first fluid channel 50 is Q1=Q2+Q3, where Q2<Q3. After the fluid flowing through the first fluid channel 50 is converged by using the re-allocation module, a flow direction of the fluid is blocked by the first flow blocking region 121 and the second flow blocking region 122, and the fluid is converged by using the re-allocation module. After the fluid is allocated by the re-allocation module, a flow rate of the third fluid entering the third subchannel 61 by using the first flow blocking region 121 is Q4, and a flow rate of the fourth fluid entering the fourth subchannel 62 by using the second flow blocking region 122 is Q5. A total flow rate of fluid in the second fluid channel 60 is Q1=Q4+Q5, where Q3>Q5. It can be learned from the foregoing description that when fluid flows in the direction a, allocation of flow rates of the fluid in different subchannels of a fluid channel may be controlled by using the re-allocation module, so that a flow rate of corresponding allocated fluid can be properly adjusted in an actual component arrangement manner, thereby improving a heat dissipation effect on the component.

In an optional solution, the re-allocation module includes a convergence cavity 11 and a distribution module 12. The convergence cavity 11 is connected to the upstream fluid channel, and is configured to converge the fluid in the upstream fluid channel. The convergence cavity 11 is a region between the first fluid channel 50 and the distribution module 12. The region may be formed by disposing a wall structure that is connected to the distribution module 12 and that is on the base plate of the liquid cooling cold plate 100, or may be formed by using the housing of the liquid cooling cold plate 100. The fluid (the flow rate Q2) flowing through the first subchannel 51 and the fluid (the flow rate Q3) flowing through the second subchannel 52 are converged in the convergence cavity 11. The distribution module 12 is configured to form the first flow blocking region 121 and the second flow blocking region 122. Specifically, distribution channels disposed on the distribution module 12 are used for implementation. Different distribution channels are disposed in the first flow blocking region 121 and the second flow blocking region 122, to implement different fluid resistance. For example, a cross-flow area of a channel through which fluid can pass in the distribution channel disposed in the first flow blocking region 121 is A, and a cross-flow area of a channel through which fluid can pass in a distribution channel disposed in the second flow blocking region 122 is B. If A>B, the fluid resistance of the first flow blocking region 121 is less than the fluid resistance of the second flow blocking region 122. The foregoing distribution module 12 and the fluid channel may be implemented in different manners. The following is separately described with reference to the accompanying drawings.

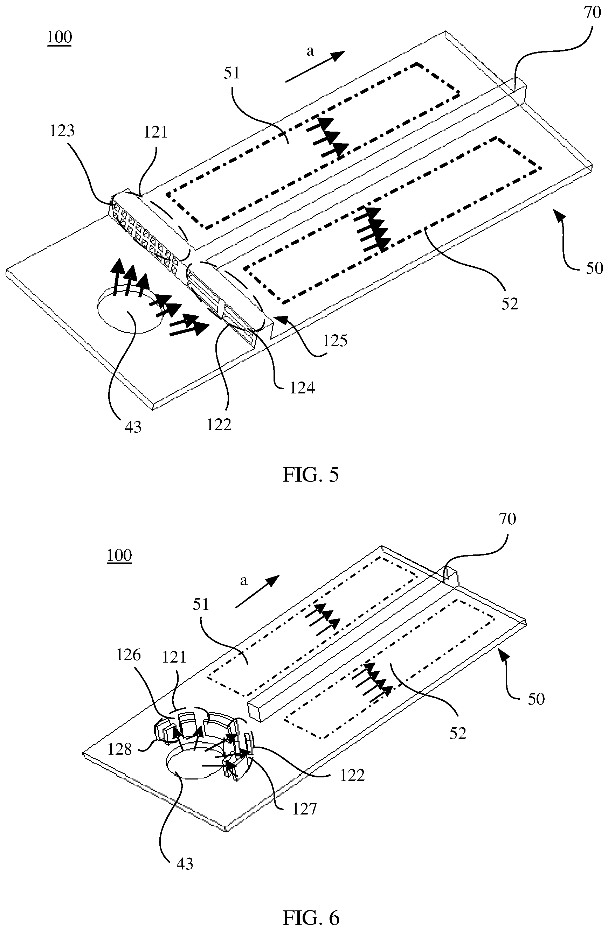

FIG. 5 shows a specific structure of a specific distribution module. In FIG. 5, the re-allocation module may be disposed between the liquid inlet 43 and the first fluid channel 50, and a principle thereof is the same as a principle of disposing the re-allocation module between the first fluid channel 50 and the second fluid channel. The distribution module includes a stopper 125. For example, the stopper 125 is a rectangular stopper, and a length direction of the stopper 125 is perpendicular to the flow direction of the fluid, to separate the liquid inlet 43 and the first fluid channel 50. A plurality of through holes are disposed on the stopper 125, and the plurality of through holes are distribution channels. The plurality of through holes are divided into first through holes 123 and second through holes 124. The first through holes 123 are disposed in the first flow blocking region 121, the second through holes 124 are disposed in the second flow blocking region 122, and pore sizes of through holes in different flow blocking regions are different. For example, two rows of first through holes 123 arranged into an array are disposed in the first flow blocking region 121, and two rows of second through holes 124 arranged into an array are disposed in the second flow blocking region 122. Both the first through hole 123 and the second through hole 124 are rectangular through holes, and an opening area of the first through hole 123 is less than an opening area of the second through hole 124. A total opening area of all the first through holes 123 in the first flow blocking region 121 is C, and a total opening area of the second through holes 124 in the second flow blocking region 122 is D, where C<D. When fluid flows through the distribution module, a flow rate flowing in the first subchannel 51 and a flow rate flowing in the second subchannel 52 meet: Q2<Q3.

In an optional implementation of this example helpful to understand the application, the through holes provided in this example helpful to understand this application may be arranged in different quantities of rows, for example, a single row or three rows. This is not specifically limited in this application.

In an optional implementation of this example helpful to understand the application, the through holes may be holes of different shapes, such as circular holes, rhombic holes, or elliptical holes that all may be applied to this example helpful to understand this application.

In an optional implementation of this example helpful to understand the application, the opening area of the first through hole 123 and the opening area of the second through hole 124 may be the same. Different quantities of first through holes 123 and second through holes 124 may be disposed by using the first flow blocking region 121 and the second flow blocking region 122, to implement different fluid resistance of the first flow blocking region 121 and the second flow blocking region 122.

In an optional implementation of this example helpful to understand the application, different shapes may be alternatively selected for the stopper 125, such as a V shape or an arc-shaped shape. However, regardless of which shape is selected, a concave direction of the stopper 125 faces the upstream fluid channel or the liquid inlet 43. A region surrounded by a concave surface of the stopper 125 may be used as the convergence cavity.

In an optional implementation of this example helpful to understand the application, the distribution module further includes a baffle plate 70, and the baffle plate 70 extends in the flow direction of the fluid and is configured to space any two adjacent heat dissipation sub-regions, so that the two adjacent heat dissipation sub-regions can be separated. That the adjacent heat dissipation sub-regions are separated means that the baffle plate 70 is located in the fluid channel and separates two subchannels corresponding to two heat dissipation sub-regions. As shown in FIG. 5, the first fluid channel 50 includes the first subchannel 51 and the second subchannel 52, and the first subchannel 51 and the second subchannel 52 are separated by using the baffle plate 70, to avoid interference caused by the fluid in the first subchannel 51 to the fluid in the second subchannel 52, thereby improving a heat dissipation effect of the fluid on the component.

In an optional implementation of this example helpful to understand the application, the stopper 125 and the baffle plate 70 may have an integral structure. During specific production, the stopper 125, the baffle plate 70, and the base plate may be integrally formed, for example, produced into an integral structure in a manner such as injection molding or 3D printing. Certainly, a detachable structure may be used. In this case, the stopper 125 may be connected to the base plate in different manners such as bonding, welding, or riveting, and the baffle plate 70 may be fixedly connected to the base plate in a same manner. It should be understood that, when a detachable structure is used for the stopper 125, the baffle plate 70, and the base plate, sealing may be performed by using sealing glue, to ensure that the stopper 125 and the baffle plate 70 can separate fluid.

In an optional implementation of this example helpful to understand the application, a plurality of heat dissipation fins (not shown in the figure) are disposed in each fluid channel, the plurality of heat dissipation fins are arranged into an array in the flow direction of the fluid, and a channel for fluid flow is left between the heat dissipation fins. When the fluid flows through the heat dissipation fins, the fluid can absorb heat transferred by the component to the heat dissipation fins, thereby improving a heat dissipation effect on the component.

FIG. 6 is another schematic structural diagram of a distribution module. In FIG. 6, the re-allocation module may be disposed between the liquid inlet 43 and the first fluid channel 50, and a principle thereof is the same as a principle of disposing the re-allocation module between the first fluid channel 50 and the second fluid channel. The distribution module includes a plurality of distribution plates 128. The plurality of distribution plates 128 are disposed around the liquid inlet 43, and the convergence cavity is surrounded by the plurality of distribution plates 128. In addition, the plurality of distribution plates 128 are spaced from each other by gaps, and the gaps are distribution channels. For ease of description, a plurality of gaps are divided into first gaps 126 and second gaps 127. The first gaps 126 are disposed in the first flow blocking region 121, the second gaps 127 are disposed in the second flow blocking region 122, and gaps in different flow blocking regions have different sizes. For example, an opening area of the first gap 126 is less than an opening area of the second gap 127. A total opening area of all first gaps 126 in the first region is E, and a total opening area of second gaps 127 in the second flow blocking region 122 is F, where E<F. When fluid flows through the distribution module, a flow rate flowing in the first subchannel and a flow rate flowing in the second subchannel meet: Q2<Q3.

In an optional implementation of this example helpful to understand the application, the opening area of the first gap 126 and the opening area of the second gap 127 may be the same. Different quantities of first gaps 126 and second gaps 127 may be disposed by using the first flow blocking region 121 and the second flow blocking region 122, to implement different fluid resistance of the first flow blocking region 121 and the second flow blocking region 122.

In an optional implementation of this example helpful to understand the application, the distribution plates 128 are arc-shaped distribution plates, and a semi-cylindrical convergence cavity is surrounded by the distribution plates 128, and an opening direction of the convergence cavity faces the upstream fluid channel. After fluid flowing through the liquid inlet 43 is converged by using the convergence cavity, the fluid is re-allocated by using the distribution plates 128.

In an optional implementation of this example helpful to understand the application, the distribution plates 128 are arranged into two layers. As shown in FIG. 6, the distribution plates 128 are arranged into two layers in a direction away from the liquid inlet 43. Certainly, the distribution plates 128 may be arranged into a plurality of different quantities of layers, for example, one layer or three layers.

In an optional implementation of this example helpful to understand the application, the distribution module further includes a baffle plate 70, and the baffle plate 70 extends in the flow direction of the fluid and is configured to space any two adjacent heat dissipation sub-regions, so that the two adjacent heat dissipation sub-regions can be separated. That the adjacent heat dissipation sub-regions are separated means that the baffle plate 70 is located in the fluid channel and separates two subchannels corresponding to two heat dissipation sub-regions. As shown in FIG. 5, the first fluid channel 50 includes the first subchannel 51 and the second subchannel 52, and the first subchannel 51 and the second subchannel 52 are separated by using the baffle plate 70, to avoid interference caused by the fluid in the first subchannel 51 to the fluid in the second subchannel 52, thereby improving a heat dissipation effect of the fluid on the component.

In an optional implementation of this example helpful to understand the application, the distribution plates 128 and the baffle plate 70 have a detachable structure. During specific production, the distribution plates 128 and the base plate, and the baffle plate 70 and the base plate may be integrally formed, for example, produced into an integral structure in a manner such as injection molding or 3D printing. Certainly, a detachable structure may be used. In this case, the distribution plates 128 may be connected to the base plate in different manners such as bonding, welding, or riveting, and the baffle plate 70 may be fixedly connected to the base plate in a same manner. It should be understood that, when a detachable structure is used for the distribution plates 128, the baffle plate 70, and the base plate, sealing may be performed by using sealing glue, to ensure that the distribution plates 128 and the baffle plate 70 can separate fluid.

In an optional implementation of this example helpful to understand the application, a plurality of heat dissipation fins (not shown in the figure) are disposed in each fluid channel, the plurality of heat dissipation fins are arranged into an array in the flow direction of the fluid, and a channel for fluid flow is left between the heat dissipation fins. When the fluid flows through the heat dissipation fins, the fluid can absorb heat transferred by the component to the heat dissipation fins, thereby improving a heat dissipation effect on the component. During specific production, the heat dissipation fins may be produced on the base plate through integral production, or may be fastened to the base plate in a manner such as bonding, welding, or riveting.

It may be learned from the foregoing description that the liquid cooling cold plate 100 provided in this example helpful to understand this application can meet heat dissipation requirements of component arrangement of different heat dissipation requirements. When heat dissipation requirements of heat sources disposed in heat dissipation regions are different, the fluid in the upstream fluid channel is converged by using the re-allocation module, and the entire converged fluid is re-allocated to a downstream heat dissipation region. Circulation of distribution-convergence-distribution is set for the entire fluid, so that corresponding flow rates can be provided to regions with different heat dissipation requirements in the downstream heat dissipation region. In addition, a fluid channel setting is simplified, so that different flow rates can be allocated between the upstream and downstream fluid channels, thereby improving a heat dissipation effect.

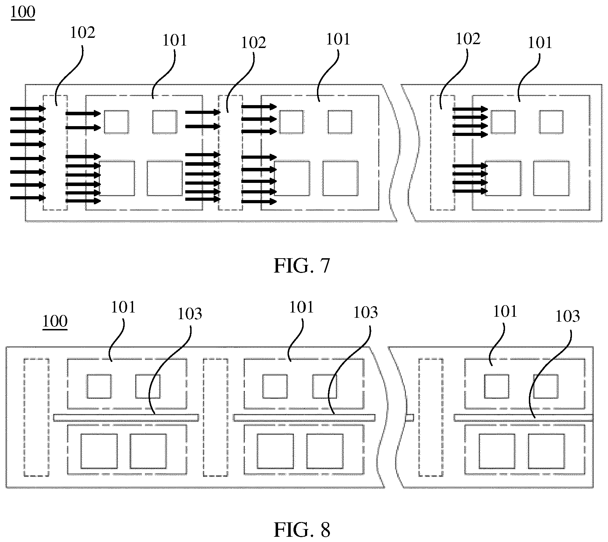

As an expansion solution, as shown in FIG. 7, the liquid cooling cold plate provided in this embodiment of this application may include a plurality of different quantities of heat dissipation regions 101, for example, three or four. A plurality of heat dissipation regions 101 are also arranged in a single row in the direction a. When a re-allocation module 102 is disposed, the re-allocation module 102 may be disposed between any adjacent heat dissipation regions 101, or the re-allocation module 102 may be disposed only between some adjacent heat dissipation regions 101. Alternatively, the re-allocation module 102 is disposed between the liquid inlet and an adjacent heat dissipation region 101. In any one of the foregoing cases, a heat dissipation effect of the liquid cooling cold plate 100 can be improved.

As shown in FIG. 8, when a plurality of heat dissipation regions 101 are used, a baffle plate 103 may be disposed in any fluid channel, or a baffle plate 103 may be disposed in some fluid channels.

When a plurality of heat dissipation regions 101 are used, heat dissipation fins may be disposed in each fluid channel, or heat dissipation fins may be disposed only in some fluid channels.
An embodiment of this application provides a communications device, and the communications device may be different communications devices such as a cabinet and a base station. The communications device includes the liquid cooling cold plate in any one of the foregoing implementations and an electronic component disposed in each heat dissipation region. Fluid in an upstream fluid channel is converged by using a re-allocation module, and the entire converged fluid is re-allocated to a downstream heat dissipation region, so that corresponding flow rates can be provided to regions with different heat dissipation requirements in the downstream heat dissipation region.

## Claims

1. A liquid cooling cold plate (100), comprising a housing (40) and at least two heat dissipation regions (20, 30) arranged on the housing (40) in a flow direction of fluid, direction a, wherein a fluid channel (50, 60) corresponding to each heat dissipation region (20, 30) is disposed in the housing (40), and a re-allocation module (10) is disposed between at least two adjacent fluid channels (50, 60); and
fluid in a fluid channel (50) located upstream of the re-allocation module (10) is converged by using the re-allocation module (10), and the converged fluid is distributed to a downstream fluid channel (60) by using the re-allocation module (10);
wherein the re-allocation module (10) has regions with different fluid resistance;
**characterized in that**
each heat dissipation region (20, 30) includes at least two heat dissipation sub-regions (21, 22, 31, 32) arranged in a direction b, which is perpendicular to the flow direction, wherein powers of components in the heat dissipation sub-regions are different;
the re-allocation module (10) allocates the converged fluid to different regions in the downstream fluid channel (60) based on a specified flow rate by using the regions with different fluid resistance;
the re-allocation module (10) comprises a convergence cavity (11) and a distribution module (12), wherein
the convergence cavity (11) is connected to the upstream fluid channel, and is configured to converge the fluid in the upstream fluid channel (50);
distribution channels are disposed on the distribution module (12), and the distribution channels are separately connected to the convergence cavity (11) and the downstream fluid channel (60); and
fluid in the upstream fluid channel (50) is converged by using the convergence cavity (11), and the converged fluid is distributed again by using the distribution module (12).

2. The liquid cooling cold plate (100) according to claim 1, wherein at least two heat dissipation sub-regions that have different heat dissipation requirements are disposed in a downstream heat dissipation region; and
the distribution module (12) further comprises a baffle plate (103), and the baffle plate (103) extends in the flow direction of the fluid and is configured to space any two adjacent heat dissipation sub-regions.

3. The liquid cooling cold plate (100) according to any one of claims 1 or 2, wherein a plurality of heat dissipation fins are disposed in each fluid channel (50, 60).

4. The liquid cooling cold plate (100) according to any one of claims 1 to 3, wherein the housing (40) comprises a base plate (42) and an upper cover (41) covering the base plate (42), and the re-allocation module (10) and the fluid channel (50, 60) in each heat dissipation region (20, 30) are located in a cavity (11) surrounded by the upper cover (41) and the base plate (42).

5. A communications device, comprising the liquid cooling cold plate (100) according to any one of claims 1 to 4 and an electronic component disposed in each heat dissipation region (20, 30).

## Patentansprüche

1. Flüssigkeitskühlende Kaltplatte (100), umfassend ein Gehäuse (40) und mindestens zwei Wärmeableitungsbereiche (20, 30), die an dem Gehäuse (40) in einer Strömungsrichtung eines Fluids, Richtung a, angeordnet sind, wobei ein Fluidkanal (50, 60), der jedem Wärmeableitungsbereich (20, 30) entspricht, in dem Gehäuse (40) angeordnet ist, und ein Neuzuweisungsmodul (10) zwischen mindestens zwei benachbarten Fluidkanälen (50, 60) angeordnet ist; und
Fluid in einem Fluidkanal (50), der sich stromaufwärts des Neuzuweisungsmoduls (10) befindet, unter Verwendung des Neuzuweisungsmoduls (10) zusammengeführt wird, und das zusammengeführte Fluid unter Verwendung des Neuzuweisungsmoduls (10) auf einen stromabwärts gelegenen Fluidkanal (60) verteilt wird;
wobei das Neuzuweisungsmodul (10) Bereiche mit unterschiedlichem Fluidwiderstand aufweist;
**dadurch gekennzeichnet, dass**
jeder Wärmeableitungsbereich (20, 30) mindestens zwei Wärmeableitungsunterbereiche (21, 22, 31, 32) enthält, die in einer Richtung b angeordnet sind, die rechtwinklig zur Strömungsrichtung verläuft, wobei die Leistungen der Komponenten in den Wärmeableitungsunterbereichen unterschiedlich sind;
das Neuzuweisungsmodul (10) das zusammengeführte Fluid verschiedenen Bereichen in dem stromabwärts gelegenen Fluidkanal (60) durch Verwendung der Bereiche mit unterschiedlichem Fluidwiderstand basierend auf einer vorgegebenen Durchflussrate zuweist;
das Neuzuweisungsmodul (10) einen Zusammenführungshohlraum (11) und ein Verteilungsmodul (12) umfasst, wobei
der Zusammenführungshohlraum (11) mit dem stromaufwärts gelegenen Fluidkanal verbunden und dazu ausgelegt ist, das Fluid im stromaufwärts gelegenen Fluidkanal (50) zusammenzuführen;
Verteilungskanäle auf dem Verteilungsmodul (12) angeordnet sind und die Verteilungskanäle separat mit dem Zusammenführungshohlraum (11) und dem stromabwärts gelegenen Fluidkanal (60) verbunden sind; und
das Fluid im stromaufwärts gelegenen Fluidkanal (50) mittels des Zusammenführungshohlraums (11) zusammengeführt wird, und das zusammengeführte Fluid mittels des Verteilungsmoduls (12) wieder verteilt wird.

2. Flüssigkeitskühlende Kaltplatte (100) gemäß Anspruch 1, wobei in einem stromabwärts gelegenen Wärmeableitungsbereich mindestens zwei Wärmeableitungsteilbereiche angeordnet sind, die unterschiedliche Wärmeableitungsanforderungen aufweisen; und
das Verteilungsmodul (12) ferner eine Ablenkplatte (103) umfasst, und die Ablenkplatte (103) sich in Strömungsrichtung des Fluids erstreckt und dazu ausgelegt ist, zwei beliebige benachbarte Wärmeableitungsunterbereiche zu beabstanden.

3. Flüssigkeitskühlende Kaltplatte (100) gemäß einem der Ansprüche 1 oder 2, wobei in jedem Fluidkanal (50, 60) eine Vielzahl von Wärmeableitungsrippen angeordnet ist.

4. Flüssigkeitskühlende Kaltplatte (100) gemäß einem der Ansprüche 1 bis 3, wobei das Gehäuse (40) eine Basisplatte (42) und eine obere Abdeckung (41) umfasst, die die Basisplatte (42) abdeckt, und das Neuzuweisungsmodul (10) und der Fluidkanal (50, 60) in jedem Wärmeableitungsbereich (20, 30) in einem Hohlraum (11) angeordnet sind, der durch die obere Abdeckung (41) und die Basisplatte (42) umgeben ist.

5. Kommunikationsvorrichtung, umfassend die flüssigkeitskühlende Kaltplatte (100) gemäß einem der Ansprüche 1 bis 4 und eine in jedem Wärmeableitungsbereich (20, 30) angeordnete elektronische Komponente.

## Revendications

1. Plaque froide à refroidissement liquide (100), comprenant un boîtier (40) et au moins deux régions de dissipation de chaleur (20, 30) agencées sur le boîtier (40) dans une direction d'écoulement de fluide (direction a), un canal de fluide (50, 60) correspondant à chaque région de dissipation de chaleur (20, 30) étant disposé dans le boîtier (40), et un module de réaffectation (10) étant disposé entre au moins deux canaux de fluide (50, 60) adjacents ; et
un fluide dans un canal de fluide (50) situé en amont du module de réaffectation (10) étant fait converger au moyen du module de réaffectation (10), et le fluide convergé étant distribué vers un canal de fluide (60) en aval au moyen du module de réaffectation (10) ;
le module de réaffectation (10) ayant des régions avec une résistance de fluide différente ;
**caractérisée en ce que** :
chaque région de dissipation de chaleur (20, 30) comprend au moins deux sous-régions de dissipation de chaleur (21, 22, 31, 32) agencées dans une direction b qui est perpendiculaire à la direction d'écoulement, des composantes actives dans les sous-régions de dissipation de chaleur étant différentes ;
le module de réaffectation (10) affecte le fluide convergé à différentes régions dans le canal de fluide (60) en aval sur la base d'un débit spécifié au moyen des régions avec une résistance de fluide différente ;
le module de réaffectation (10) comprend une cavité de convergence (11) et un module de distribution (12), la cavité de convergence (11) étant connectée au canal de fluide en amont et étant configurée pour faire converger le fluide dans le canal de fluide (50) en amont ;
des canaux de distribution sont disposés sur le module de distribution (12), et les canaux de distribution sont reliés séparément à la cavité de convergence (11) et au canal de fluide (60) en aval ; et
un fluide dans le canal de fluide (50) en amont est fait converger au moyen de la cavité de convergence (11), et le fluide convergé est distribué à nouveau au moyen du module de distribution (12).

2. Plaque froide à refroidissement liquide (100) selon la revendication 1, dans laquelle au moins deux sous-régions de dissipation de chaleur qui ont des exigences différentes en matière de dissipation de chaleur sont disposées dans une région de dissipation de chaleur en aval ; et
le module de distribution (12) comprend en outre une plaque déflectrice (103), la plaque déflectrice (103) s'étendant dans la direction d'écoulement du fluide et étant configurée pour espacer deux quelconques sous-régions de dissipation de chaleur adjacentes.

3. Plaque froide à refroidissement liquide (100) selon l'une quelconque des revendications 1 et 2, dans laquelle une pluralité d'ailettes de dissipation de chaleur sont disposées dans chaque canal de fluide (50, 60).

4. Plaque froide à refroidissement liquide (100) selon l'une quelconque des revendications 1 à 3, dans laquelle le boîtier (40) comprend une plaque de base (42) et un couvercle supérieur (41) recouvrant la plaque de base (42), le module de réaffectation (10) et le canal de fluide (50, 60) dans chaque région de dissipation de chaleur (20, 30) étant situés dans une cavité (11) entourée par le couvercle supérieur (41) et la plaque de base (42).

5. Dispositif de communication, comprenant la plaque froide à refroidissement liquide (100) selon l'une quelconque des revendications 1 à 4 et un composant électronique disposé dans chaque région de dissipation de chaleur (20, 30).
